# EUROPEAN PATENT APPLICATION

(11) **EP 4 321 933 A1**
(43) Date of publication of application: **14.02.2024**
(21) Application number: 22189424.9
(22) Date of filing: 09.08.2022
(51) Int. Cl.: G03F 7/20, G01N 21/95, G01N 21/956, G02F 1/35, H05G 2/00

(54) **A RADIATION SOURCE**

(71) Applicant: ASML Netherlands B.V., 5500 AH Veldhoven (NL)
(72) Inventor: EDWARD, Stephen, 5500 AH Veldhoven (NL)
(74) Representative: ASML Netherlands B.V.

(57) **Abstract**

A beam metrology device (BMD) for determining at least one characteristic of first radiation (IRD; AIRD) and/or at least one characteristic of second radiation (ORD), said second radiation being generated via a first nonlinear process upon receiving a first portion (AIRD-1) of the first radiation; the beam metrology device comprising: a metrology device nonlinear medium (NLE) configured to receive a second portion (AIRD-2) of the first radiation and thereby to generate third radiation (NRD) via a second nonlinear process; at least one detector (PSD3; PSD4) configured to measure at least one characteristic of the third radiation; and a processing unit operable to determine the at least one characteristic of the first radiation and/or the at least one characteristic of the second radiation based on said at least one characteristic of the third radiation.

## Description

### FIELD

The present invention relates to a radiation source, in particular a high harmonic generation radiation source, and such a radiation source in relation to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

It is desirable to improve on present radiation sources for high harmonic generation.

### SUMMARY

According to a first aspect of the present invention, there is provided a beam metrology device for determining at least one characteristic of first radiation and/or at least one characteristic of second radiation, said second radiation being generated via a first nonlinear process upon receiving a first portion of the first radiation; the beam metrology device comprising: a metrology device nonlinear medium configured to receive a second portion of the first radiation and thereby to generate third radiation via a second nonlinear process; at least one detector configured to measure at least one characteristic of the third radiation; and a processing unit operable to determine the at least one characteristic of the first radiation and/or the at least one characteristic of the second radiation based on said at least one characteristic of the third radiation.

According to a second aspect of the present invention, there is provided a radiation source, comprising: a beam metrology device of the first aspect; a source nonlinear medium configured to generate the second radiation via the first nonlinear process upon receiving the first portion of first radiation; and a radiation configuration arrangement being operable to configure at least one characteristic of the first radiation so as to actuate said control action.

According to a third aspect of the present invention, there is provided a method for controlling a radiation source, comprising: generating second radiation via a first nonlinear process upon receiving a first portion of a first radiation by a source nonlinear medium; generating third radiation via a second nonlinear process upon receiving a second portion of the first radiation by a metrology nonlinear medium; measuring at least one characteristic of the third radiation; and controlling said at least one characteristic of said first radiation in generating said second radiation based on said at least one characteristic of the third radiation.

Other aspects of the invention comprise metrology device comprising the radiation source of the second aspect.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8A schematically depicts an example pump radiation rejection scheme optimally implemented in a HHG radiation source;
- Figure 8B schematically depicts a suboptimal situation where the example pump radiation rejection scheme of Figure 8A loses its effect in blocking the remaining pump radiation due to beam misalignment;
- Figure 8C schematically depicts another suboptimal situation where the example pump radiation rejection scheme of Figure 8A loses its effect in blocking the remaining pump radiation due to a change in the focus position of the lens;
- Figure 9 schematically depicts an example HHG radiation source stabilized by an existing active beam stabilization arrangement;
- Figure 10 schematically depicts an example HHG radiation source stabilized by the proposed beam metrology device in accordance with an embodiment; and
- Figure 11 schematically depicts an example HHG radiation source stabilized by the proposed beam metrology device in accordance with a different embodiment.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

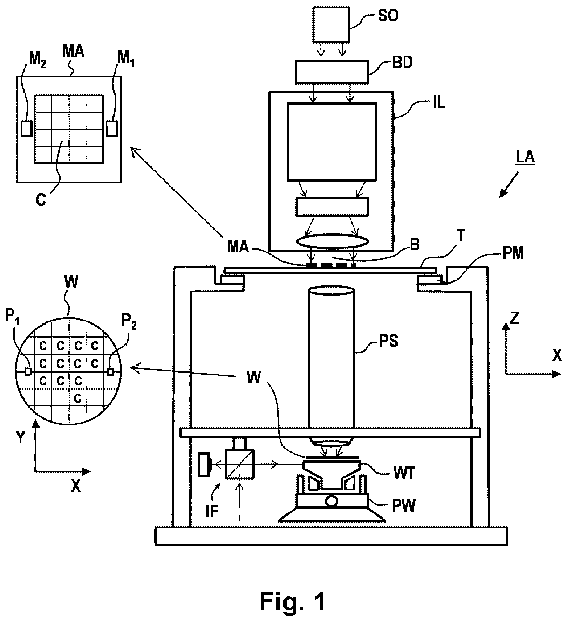

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

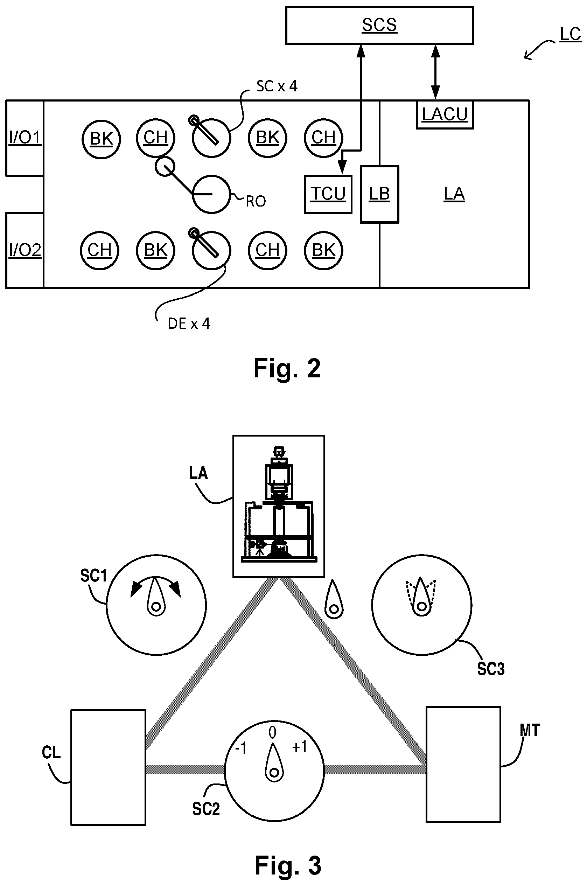

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

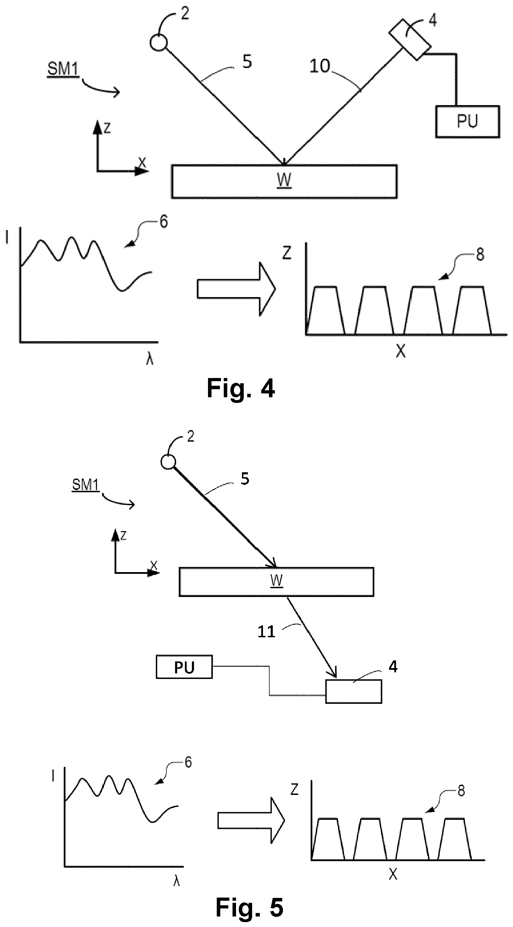

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

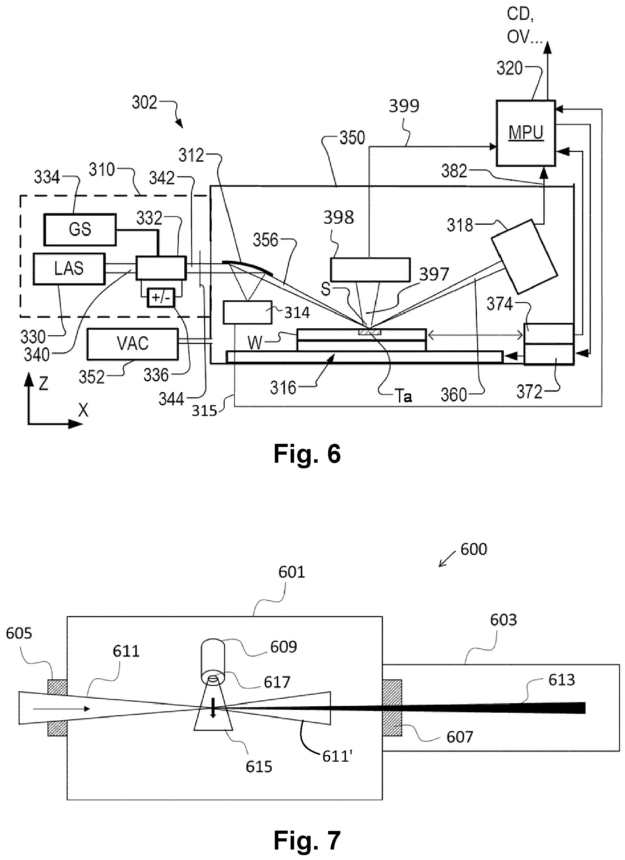

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 (or drive radiation) with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV, SXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV, SXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation may need to be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focused onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Referring back to Figure 7, an important aspect of any HHG source is that the HHG radiation is emitted into the same direction as the powerful pump radiation. This is why it is necessary to adopt a pump radiation rejection scheme to separate the remaining unconverted pump radiation from the emitted HHG radiation, as described above. In the case where a HHG source is used in a metrology tool MT (e.g., as shown in Figure 6), a good separation of the pump and HHG radiation may 1) protect the sensitive HHG optics used downstream e.g., to refocus the HHG radiation to a target, 2) prevent laser damage to a metrology target, and 3) prevent that the emitted weak HHG radiation is buried in a powerful background of the remaining pump radiation.

Existing pump radiation rejection schemes typically rely on using a radiation block to block the majority of the remaining pump radiation. In some example schemes, the radiation blocking means may comprise an aperture (or a pinhole mirror, i.e. a mirror with a hole in the center) that preferentially blocks (or deflects in case of a pinhole mirror) the more divergent pump laser beam while allowing the HHG radiation to pass through the hole without being attenuated. In some example schemes, the radiation block may comprise a Brewster plate that preferentially reflects the HHG radiation while allowing the remaining pump radiation to pass through the Brewster plate and get blocked e.g., by a beam block. In other example schemes, the radiation block may be wire meshes that preferentially transmit the HHG radiation. A typical blocking ratio for any of the above-mentioned pump radiation rejection schemes lies in the range between 10³ and 10⁶. Here, the blocking ratio is the ratio of the power of the total pump radiation over the power of the leaked pump radiation along the path of the HHG radiation. Often, a single pump radiation rejection scheme may not provide a high blocking ratio (e.g., on the order of 10⁸) that is desired by a certain application (e.g., metrology). Therefore, an additional separation step or scheme is needed to further enhance the blocking ratio. The second separation step may be done for example by inserting one or more membrane metal filters (e.g., Al or Zr membrane filters) into the beam of the HHG radiation. Such membrane metal filers impose strong attenuation on the remaining pump radiation that is not blocked by the first separation step while allowing the HHG radiation to pass through with relatively low or negligible attenuation. The membrane metal filters (e.g., Al or Zr membrane filters) may have a thickness of for example several hundreds of nanometers.

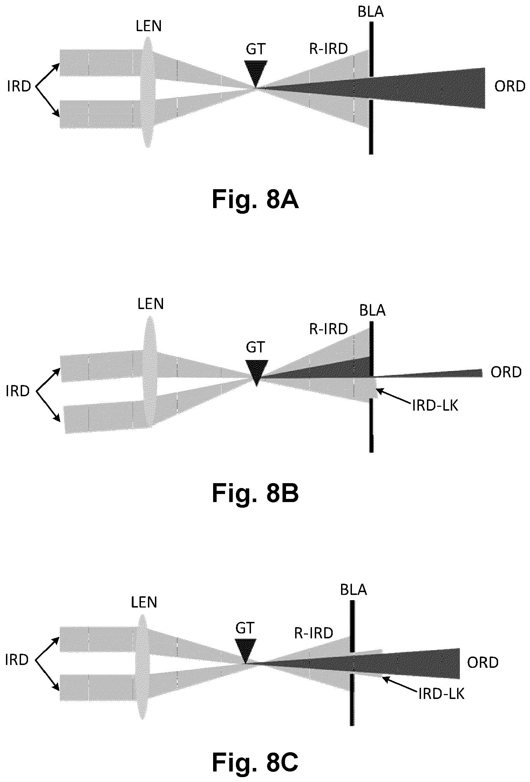

It has been found that the working of any existing pump radiation rejection scheme is sensitive to beam misalignment. If everything is optimally aligned, the remaining un-converted pump radiation can be effectively blocked. Otherwise, any small misalignment could potentially cause a significant degradation in the effectiveness of blocking the remaining pump radiation. Figure 8A schematically depicts an example pump radiation rejection scheme optimally implemented in a HHG radiation source. As shown in Figure 8A, the input pump radiation IRD having an annular transversal cross-sectional profile is focused by a lens LEN onto the gas target GT. The position and tilting (or pointing) of the focused pump radiation IRD are optimized with respect to the gas target for the best HHG efficiency. The remaining unconverted pump radiation R-IRD and the emitted HHG radiation ORD propagate along the same direction, wherein the central axes of the emitted HHG radiation ORD is collinear with the central axes of the remaining pump radiation R-IRD. The annular beam profile of the pump radiation IRD is advantageous over for example a Gaussian beam profile as it allows the remaining pump radiation R-IRD to be spatially separable from the co-propagating HGG radiation, thereby facilitating the effective blocking of the remaining pump radiation R-IRD. A pump blocking aperture BLA is optimally positioned so as to effectively block the remaining pump radiation R-IRD while allowing the HHG radiation to pass through the hole without clipping. The optimal beam alignment illustrated in Figure 8A is usually achieved by an initial optimization of a HHG source at a low pump laser power (e.g., < 1 Watt (W)). Once the initial optimization is done, the power of the pump radiation is then incrementally increased from the lower power to a higher power (e.g., 100 W) to reach a desired power level for the HHG radiation.

As the power of the pump radiation is increased, the initial optimal beam alignment shown in Figure 8A changes or degrades due to one or more thermal effects both inside the pump radiation source and in the optical beam path. Thermal effects can negatively impact the beam alignment through several different ways. For example, absorption of a small portion of the pump radiation can cause local heating of a component (e.g., a mirror) located either inside the pump radiation source or in the optical beam path which results in drifting of the component and thus beam misalignment. This negative effect is illustrated by the schematic shown in Figure 8B. In this example case, due to beam misalignment, the input pump radiation IRD is both tilted and offset with respect to the initial optimal beam path to the gas target GT. Deviating from the initial optimal beam path means both of the conversion efficiency of the HHG process and the blocking ratio of the blocking aperture BLA become sub-optimal. As a result, part IRD-LK of the remaining pump radiation R-IRD manages to leak through the hole of the blocking aperture BLA and at the same time the emitted HHG radiation ORD is clipped by the edge of the hole.

Moreover, absorption of a small portion of the pump radiation can also cause thermal lensing of a transmissive component (e.g., a focusing lens) located either inside the pump radiation source or in the optical beam path. Thermal lensing can change the divergence of the pump radiation beam and thus cause direct or indirect beam alignment changes. This negative effect is illustrated by the schematic shown in Figure 8C. In this example case, the thermal lensing effect changes the effective focal length of the lens LEN. Such a change in the effective focal length of the lens LEN causes the focus of the pump radiation IRD to be displaced from the initial optimal position, thereby resulting in a sub-optimal HHG conversion efficiency. The change in the effective focal length of the lens LEN also changes the divergence of the emitted HHG radiation as well as the remaining un-converted drive radiation, which in turn degrades the blocking ratio of the blocking aperture and allows part IRD-LK of the remaining pump radiation R-IRD to leak through its hole.

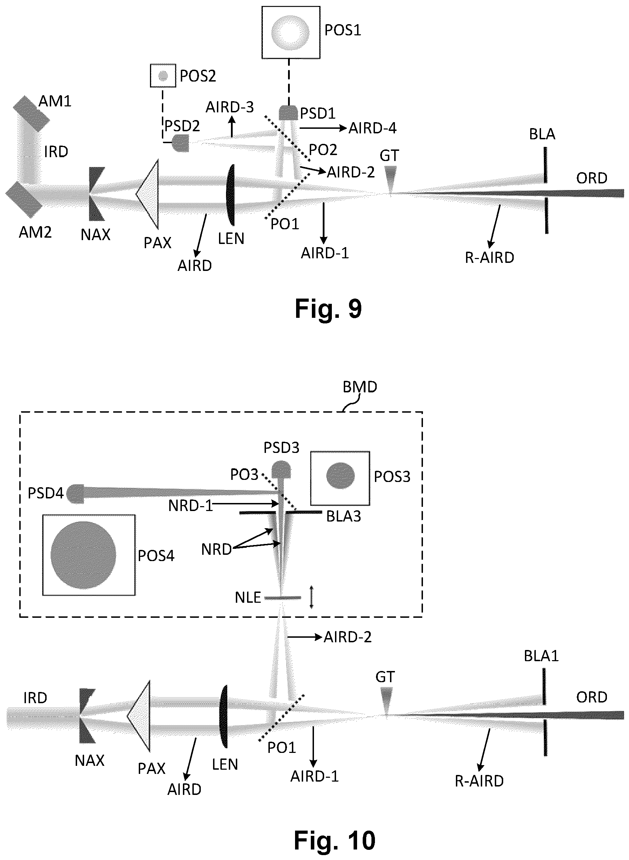

In addition to the aforementioned thermal effects, external disturbances (e.g., vibrations) can also cause beam misalignment in a HHG source due to e.g., drifting of one or more components of the source. Beam misalignments can be corrected for example by realigning the pump radiation IRD to the gas target GT, and/or by re-optimizing the gas target GT, and/or by realigning the blocking aperture BLA with respect to the remaining pump radiation and the HHG radiation. At present, active pump beam stabilization techniques have been implemented in existing HHG radiation sources to deal with the misalignment issues. Figure 9 schematically depicts an example HHG radiation source stabilized by an existing active beam stabilization arrangement. As shown in Figure 9, two actuatable mirrors AMI, AM2 (e.g., actuated by piezoelectric transducers or electromagnetic motors) are used to controllably steer the input pump radiation IRD through a negative axicon NAX and a positive axicon PAX. The axicon pair is utilized to convert for example a Gaussian beam profile to an annular beam profile. The annularly shaped pump beam AIRD is then focused onto a gas target GT by a focusing lens LEN. Between the lens LEN and the gas target GT, there exists a first pick off PO1 configured to reflect off a small portion AIRD-2 of the pump radiation AIRD for beam stabilization (see below) while transmitting a majority portion AIRD-1 for the HHG process at the gas target GT.

The emitted HHG radiation ORD and the remaining pump radiation R-AIRD propagate collinearly towards the blocking aperture BLA. Since the remaining pump radiation R-AIRD has an annular beam profile, it is possible to spatially separate the remaining pump radiation R-AIRD from the emitted HHG radiation by selecting suitable axicons NAX, PAX and/or focusing lens LEN. For example, the lens combination may be selected in such a manner that the remaining pump radiation R-AIRD has a larger divergence than the emitted HHG radiation and as such the emitted HHG radiation is surrounded by and spatially separated from the remaining pump radiation R-AIRD, as shown in Figure 9. The blocking aperture BLA is then used to completely block the remaining pump radiation R-AIRD so as to only allow the HHG radiation ORD to be output from the HHG radiation source.

The portion AIRD-2 of the pump radiation AIRD that is reflected off by the first pick off PO1 is directed into a first position sensitive detector PSD1. Between the first pick off PO1 and the first position sensitive detector PSD1, there exists a second pick off PO2 configured to direct a small portion AIRD-3 of the pump radiation AIRD-2 towards a second position sensitive detector PSD2 while transmitting the majority AIRD-4 of the pump radiation AIRD-2. The position of the pump radiation AIRD can be measured by using the first position sensitive detector PSD1 alone while the pointing (or direction) of the pump radiation AIRD can be determined based on the a first position POS1 and a second position POS2 measured respectively by the first and second position sensitive detectors PSD1, PSD2. The measurement data is sent to a processing unit which is configured to process the data (e.g., calculate the pointing change), generate a control signal based on the determined position and pointing changes of the pump radiation AIRD, and send the control signal to the actuatable mirrors AMI, AM2. Upon receiving the control signal, the actuatable mirrors AMI, AM2 will make corresponding movements (e.g., rotating and/or tilting) to correct for any drift of misalignment (e.g., position and pointing changes) of the pump radiation AIRD. Such a beam stabilization process will repeat until the position and pointing changes are minimized.

The above-described beam stabilization method has many disadvantages. First, the beam stabilization method is unreliable for non-Gaussian beams, such as annularly shaped beams. As described above, the annular beam profile is preferable over the Gaussian beam profile as it facilitates the effective blocking of the remaining pump radiation R-AIRD. The unreliability is mainly due to the fact that position sensitive detectors (e.g., PSD1, PSD2) determine the position of a beam by estimating the center-of-mass of the beam and as such it is difficult for a position sensitive detector to reliably determine the center-of-mass of an annular beam where there is no intensity in the center of the beam.

Secondly, position sensitive detectors (e.g., PSD1, PSD2) are not sensitive to any changes in the divergence and wavefront of a beam. It is known that the output performance of the HHG radiation ORD is also dependent on the divergence and wavefront of the pump radiation AIRD, both of which can degrade the HHG output (e.g., conversion efficiency and/or beam alignment) without a disturbance in the pump beam alignment (e.g., as shown in Figure 8C).

Thirdly, the beam stabilization method does not correct for the misalignment to any components (e.g., the negative axicon NAX, the positive axicon PAX, the pick off PO3) located between the second actuated mirror AM2 and the gas target GT. Correcting for the misalignment to any of those components is crucial to maintain the collinearity of the remaining pump radiation R-AIRD and the HHG radiation ORD, which in turn is crucial for achieving a high blocking ratio of the pump radiation rejection scheme.

It may be better to use the position, pointing and intensity of the HHG radiation ORD to generate a feedback control signal for optimizing the pump-gas jet alignment. However, it is hard to measure the position and pointing of the HHG radiation with a position sensitive detector due to sensitivity limitations in the desired wavelength region, e.g., 0.1 nm to 10 nm. Also, to measure the characteristics of the HHG radiation, a beam splitter or pick off is required. However, it is extremely hard to make or even impossible to make beam splitters suitable for the desired wavelength region e.g., 0.1 nm to 10 nm. Furthermore, using a beam splitter causes power loss to the HHG radiation ORD.

To mitigate some or all of the above issues, a beam metrology device and a method of controlling a radiation source are proposed hereinbelow. According to a general concept of the present disclosure, there is provided a beam metrology device for determining at least one characteristic of first radiation and/or at least one characteristic of second radiation, said second radiation being generated via a first nonlinear process upon receiving a first portion of the first radiation; the beam metrology device comprising: a metrology device nonlinear medium configured to receive a second portion of the first radiation and thereby to generate third radiation via a second nonlinear process; at least one detector configured to measure at least one characteristic of the third radiation; and a processing unit operable to determine the at least one characteristic of the first radiation and/or the at least one characteristic of the second radiation based on said at least one characteristic of the third radiation.

In an embodiment, the third radiation may have a higher frequency than the first radiation. Correspondingly, in an embodiment, the second nonlinear process may be a second harmonic generation (SHG) process. In an embodiment, the metrology device nonlinear medium may be a non-linear crystal. In an embodiment, the metrology device nonlinear medium may be for example a beta barium borate (BBO) crystal, a lithium triborate (LBO) crystal, a potassium dideuterium phosphate (KDP) or one of Its Isomorphs (KD^{∗}P (e.g., DKDP)), potassium titanyl phosphate (KTP) or a cesium lithium borate (CLBO). Please note that the above list of nonlinear crystals is non-exclusive. Other nonlinear crystals may also be suitable.

In other embodiments, the second nonlinear process may be any nonlinear process other than the SHG process. For example, in an embodiment, the second nonlinear process a third harmonic generation (THG) process. In an embodiment, the second nonlinear process may be a sum frequency generation (SFG) process. In an embodiment, the second nonlinear process may be a supercontinuum generation process. In an embodiment, the second nonlinear process may be a HHG process. In an embodiment, the second nonlinear process may be a difference frequency generation (DFG) process. In an embodiment, the second nonlinear process may be a supercontinuum generation process.

The beam profile of the third radiation may be predominantly determined by the beam profile of the second portion of the first radiation. In an embodiment, the third radiation may comprise a central portion and said at least one detector is configured to measure said at least one characteristic of the third radiation from this central portion. In an embodiment, the beam metrology device may further comprise a third radiation block configured to block a peripheral portion of the third radiation while transmitting said central portion, said peripheral portion surrounding the central portion of the generated third radiation.

In an embodiment, the at least one detector may comprise at least one position sensitive detector for determining at least a first position of the third radiation. In an embodiment, the at least one detector may comprise a first position sensitive detector and a second position sensitive detector. The first position sensitive detector and the second position sensitive detector may be separated by a distance and configured to measure respectively the first position of the third radiation and a second position of the third radiation. In an embodiment, the at least one detector may comprise a wavefront detector configured to measure a wavefront of the third radiation. The wavefront detector may be used either on its own or in combination with one or more position sensitive detectors.

In an embodiment, the first nonlinear process may be a high harmonic generation process. As such, the second radiation may be a HHG radiation emitted from a HHG radiation source. The application of the proposed beam metrology device to a HHG radiation source will be described in detail below with reference to Figure 10. In other embodiments, the first nonlinear process may be any nonlinear process other than the HHG process. For example, in an embodiment, the first nonlinear process may be a SHG process. In an embodiment, the first nonlinear process may be a third harmonic generation (THG) process. In an embodiment, the first nonlinear process may be a sum frequency generation (SFG) process. In an embodiment, the first nonlinear process may be a difference frequency generation (DFG) process. In an embodiment, the first nonlinear process may be a supercontinuum generation process.

In an embodiment, the first portion of first radiation and the second portion of first radiation may each comprise a substantially annular beam.

In an embodiment, the processing unit may be further operable to determine a control action of at least one characteristic of said first radiation in generating said second radiation based on said at least one characteristic of the third radiation. The control action may relate to a position and/or direction of the first radiation with respect to a source nonlinear medium for generating the second radiation. Alternatively or in addition, the control action may relate to a wavefront of the first radiation.

According to a general concept of the present disclosure, there is provided a radiation source, comprising: a beam metrology device as described above; a source nonlinear medium configured to generate the second radiation via the first nonlinear process upon receiving the first portion of first radiation; and a radiation configuration arrangement being operable to configure at least one characteristic of the first radiation so as to actuate said control action.

Figure 10 schematically depicts an example HHG radiation source stabilized by the proposed beam metrology device BMD (within the dashed line) in accordance with an embodiment. As shown in Figure 10, the source nonlinear medium may be a gas target GT and the first nonlinear process may be a high harmonic generation HHG process. In an embodiment, the radiation source may comprise a gas delivery system configured to provide a flow of the gas medium. In an embodiment, the radiation source may comprise a gas cell configured to at least partially enclose the gas medium. In an embodiment, the radiation source may comprise a hollow-core fiber configured to at least partially enclose the gas medium. The gas medium may be any of: air, Ne, He, N₂, O₂, Ar, Kr, Xe, carbon dioxide and the combination of them.

The first radiation IRD may have a Gaussian beam profile and the radiation source may further comprise a profile configuration arrangement being operable to impose a substantially annular profile to said first radiation. In an embodiment, said profile configuration arrangement comprises a negative axicon NAX and a positive axicon PAX. In an embodiment, the first radiation IRD may have an annular beam profile and thus the radiation source may comprise no axicons. In an embodiment, the radiation source may further comprise a focusing arrangement (e.g., a lens) LEN for focusing the first portion AIRD-1 of the first radiation AIRD onto the source nonlinear medium (e.g., a gas target GT) so as to generate the second radiation ORD via the first nonlinear process.

In an embodiment, the radiation source may further comprise a first radiation block BLA1 operable to transmit substantially only said second radiation ORD while not transmitting any of said first radiation R-AIRD. In an embodiment, the first radiation block BLA1 may comprise an aperture configured to block the remaining portion R-AIRD of the annularly shaped first radiation AIRD while allowing the second radiation ORD to pass through the hole of the aperture without being attenuated. In an embodiment, the radiation blocking means BLA may comprise a pinhole mirror comprising a central hole and configured to reflect away the remaining portion R-AIRD of the annularly shaped first radiation AIRD while allowing the second radiation ORD to pass through the central hole without being attenuated. In an embodiment, the radiation source may further comprise one or more additional radiation blocking means for improving the rejection of the remaining portion R-AIRD of the annularly shaped first radiation AIRD. In an embodiment, the one or more additional radiation blocking means may comprise one or more membrane metal filters (e.g., Al and/or Zr membrane filters).

In an embodiment, the processing unit may be operable to determine the control action of the at least one characteristic of said first radiation AIRD so as to minimize or reduce the amount of the remaining portion R-AIRD of the annularly shaped first radiation AIRD transmitted via said first radiation block BLA1 and/or maximize or increase the amount of said second radiation ORD transmitted via said first radiation block BLA1.

The radiation source may further comprise a pick off PO1, the pick off PO1 being located upstream the source nonlinear medium GT and configured to direct the second portion AIRD-2 of the first radiation AIRD towards the metrology device nonlinear medium NLE of the beam metrology device BMD. The second portion AIRD-2 of the first radiation AIRD may account for no more than 10%, no more than 5%, or no more than 1% of the total power of the first radiation AIRD. The metrology device nonlinear medium NLE may be located at the focus of the second portion AIRD-2 of the first radiation AIRD. In an embodiment, the second portion AIRD-2 of the first radiation AIRD may be a portion scattered or reflected from a component in the beam path of the first radiation, e.g., the positive axicon PAX, or the lens LEN.

Since the second portion AIRD-2 of the first radiation AIRD has an annular beam profile, the third radiation NRD generated through the SHG process comprises a central portion NRD-1 and a peripheral portion (not shown) that surrounds the central portion NRD-1. The central portion NRD-1 of the third radiation NRD is generated due to the momentum conservation of the photons (the same principle is used in intensity autocorrelators). As described above, position sensitive detectors are not reliable for measuring the position of an annularly shaped beam. Therefore, it is desirable to use only the central portion NRD-1 of the third radiation NRD. In the embodiment shown in Figure 10, the beam metrology device BMD may comprise a third radiation block BLA3 (e.g., an aperture) configured to transmit substantially only the central portion NRD-1 while not transmitting the peripheral portion of the third radiation NRD.

The beam metrology device BMD may comprise a third position sensitive detector PSD 3 and a fourth position sensitive detector PSD4. The two detectors PSD3, PSD4 may be separated by a distance and configured to respectively measure a third position POS3 and a fourth position POS4 of the central portion NRD-1 of the third radiation NRD. Based on the measured third position and fourth position of the central portion NRD-1 of the third radiation NRD, the processing unit may determine a pointing or direction of the central portion NRD-1 of the third radiation NRD. As shown in Figure 10, a third pick off PO3 may be placed in the beam path of the central portion NRD-1 of the third radiation NRD. The third pick off PO3 may be configured to reflect off a predetermined portion of the central portion NRD-1 of the third radiation NRD towards the fourth position sensitive detector PSD4 while allowing the rest of the central portion NRD-1 of the third radiation NRD to pass through so as to reach the third position sensitive detector PSD3. Similar to the methodology described above with respect to Figure 9, the position of the central portion NRD-1 of the third radiation NRD can be measured by using the third position sensitive detector PSD3 alone while the pointing or direction of the central portion NRD-1 of the third radiation NRD can be determined based on the two positions POS3, POS4 measured respectively by the third and fourth position sensitive detectors PSD3, PSD4. Alternatively or in addition, the radiation source may comprise a wavefront detector configured to measure a wavefront of the central portion NRD-1 of third radiation NRD. The information from this measurement can be used as input in a feedback loop to a wavefront configuration device for wavefront correction (see below).

Periodically or on demand, measurement data collected by the at least one detector of the beam metrology device BMD may be sent to the processing unit of the radiation source for data processing and subsequent control of the radiation configuration arrangement. In an embodiment, the radiation configuration arrangement may comprise one or more beam steering components configured to adjust a position and/or direction of the first radiation with respect to the source nonlinear medium. In an embodiment, the one or more beam steering components may comprise one or more actuatable mirrors, e.g., the actuatable mirrors AMI, AM2 shown in Figure 10. In an embodiment, the radiation configuration arrangement may comprise a wavefront configuration device configured to configure a wavefront of the first radiation. In an embodiment, the wavefront configuration device may comprise a spatial light modulator, a digital micromirror device, or a deformable mirror.

The processing unit may be operable to control the two actuatable mirrors AMI, AM2 (e.g., actuated by piezoelectric transducers or electromagnetic motors), based on the measured position and pointing changes of the central portion NRD-1 of the third radiation NRD, to adjust the position and/or pointing of the first radiation AIRD so as to minimize a change in the position and/or pointing of the second radiation ORD. The processing unit may be operable to: receive a signal indicating the position and/or pointing of the central portion NRD-1 third radiation NRD measured by the position sensitive detectors PSD3, PSD4; determine a change in the in the position and/or pointing of the central portion NRD-1 of the third radiation NRD measured by the position sensitive detectors PSD3, PSD4; and generate a control signal for controlling the radiation configuration arrangement so as to counteract the determined change in the measured position and/or pointing of the central portion NRD-1 of the third radiation NRD.

According to another general concept of the present disclosure, there is provided a method for controlling a radiation source, comprising: generating second radiation via a first nonlinear process upon receiving a first portion of a first radiation by a source nonlinear medium; generating third radiation via a second nonlinear process upon receiving a second portion of the first radiation by a metrology device nonlinear medium; measuring at least one characteristic of the third radiation; and controlling said at least one characteristic of said first radiation in generating said second radiation based on said at least one characteristic of the third radiation.

The proposed concept of using an output of a second nonlinear process to generate a feedback control signal for controlling or stabilizing an output of a first nonlinear process is advantageous over the conventional stabilization approach in which the feedback control signal is generated using an input of the first nonlinear process (e.g., the active beam stabilization arrangement implemented in the HHG source shown in Figure 9).

By way of example and with reference to Figure 10, in the case where the first nonlinear process is a HHG process and the second nonlinear process is a SHG process, the emission angle of the central portion NRD-1 of the third radiation NRD is similar to that of the second radiation ORD. If the annularly shaped first radiation AIRD is perfectly symmetric, then it is expected that the central portion NRD-1 of the third radiation NRD will be perfectly at the center. If the symmetry of the annularly shaped first radiation AIRD changes, the emission angle of the central portion NRD-1 of the third radiation NRD also changes. Since the emission angle of the second radiation ORD changes with the annularly shaped first radiation AIRD in a similar manner as the third radiation, the relative position of the central portion NRD-1 of the third radiation NRD with respect to the peripheral portion of the third radiation NRD can be a measure of the symmetry of the annularly shaped first radiation AIRD and thus an indication of the emission angle of the second radiation ORD. By comparison, the existing stabilization method (e.g., as shown in Figure 9) is not capable of measuring or determining a symmetry of the annularly shaped first radiation AIRD.

The stabilization method implemented in the HHG source shown in Figure 10 also provides information about how well the first radiation IRD is aligned on the axicons NAX, PAX (or a pinhole mirror) and also the alignment of the first radiation onto the gas target GT. If the focus position of the annularly shaped first radiation AIRD-2 shifts forward or backwards due to either misalignment or thermal lensing, the conversion efficiency of the SHG process decreases and the divergence of the third radiation NRD changes. Since the second radiation ORD will respond to the change in the focus position of the annular shaped first radiation AIRD-1 in a similar way as the third radiation, the stabilization method can be used to monitor the relative divergence change of the second radiation ORD, which is unachievable by the existing stabilization method (e.g., as shown in Figure 9). The change in the focus position can be corrected for example by moving the focusing lens LEN.

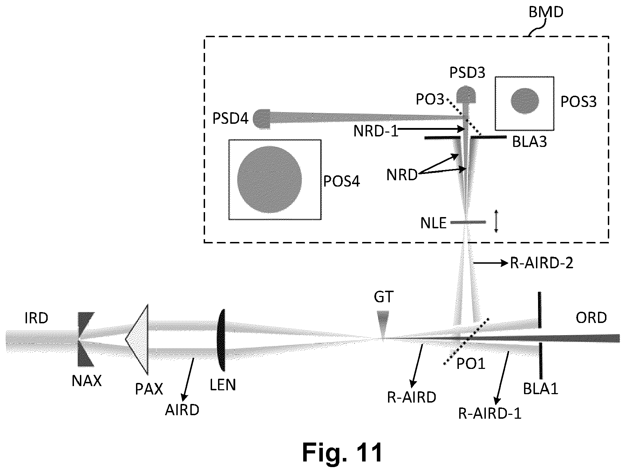

It will be appreciated that the above embodiments are provided for the purpose of describing the proposed concepts and are not intended to limit the scope of the present disclosure. Of course, other embodiments can be envisaged. With reference to Figure 11, in an embodiment, the pick off PO1 may be located downstream the source nonlinear medium GT and configured to direct a small portion R-AIRD-2 of the remaining first radiation R-AIRD towards the metrology device nonlinear medium NLE of the beam metrology device BMD. The rest R-AIRD-1 of the remaining first radiation R-AIRD that passes through the pick off PO1 may be blocked by the first radiation block BLA1, in the same manner as the embodiment shown in Figure 10. In this embodiment, the beam metrology device may be configured and function in substantially the same way as that shown in Figure 10. In comparison with the case where the pick off PO1 is located upstream the gas target GT (e.g., as shown in Figure 10), placing the pick off PO1 after the gas target GT allows any instability originated from the gas target GT to be detected by the beam metrology device BMD and be taken account of when generating the feedback control signal. For example, the gas target GT may be provided by a gas nozzle (not shown) which may drift or move over time. The drifting of the gas nozzle may degrade the spatial overlapping between the focus of the annularly shaped first radiation and the gas target GT and thus cause a change in the divergence and power of the second radiation ORD. Both changes will be caught by the beam metrology device BMD and corresponding feedback control signal will be generated for controlling the radiation configuration arrangement (e.g., one or more actuators installed on the gas nozzle for position control) so as to counteract such changes.

It will be appreciated that the characteristics of the third radiation that are measured for the purpose of controlling the corresponding characteristics of the second radiation may not be limited to beam alignment (beam position and beam pointing), divergence and wavefront, as described in the foregoing embodiments. Other different characteristics, such as spot size, centroid wavelength, bandwidth, pulse width, average power, peak power, etc, of the third radiation may also be useful. By way of example, since the intensity of the third radiation (e.g., SHG of the first radiation) is a measure of the peak intensity of the first radiation, a change in the measured intensity of the third radiation could be used to determine a change in the following pump beam parameters: (1) beam alignment, which can be compensated with e.g., actuated mirrors (as described in the embodiments shown in Figure 10 and 11); (2) pulse duration, which can be adjusted e.g., by changing the (dispersion) setting of the pump laser that emits the first radiation; (3) beam size and divergence, which can be adjusted e.g., by changing the setting of the focusing arrangement; and (4) pulse energy, which can be adjusted e.g., by diode current of the laser, for instance. Hence, the measured intensity of the third radiation can be used to determine a change in the pulse of the first radiation and actuate a corresponding control action. For example, if the change is in the pulse energy, the control action may be to adjust e.g., the diode current. Whereas, if the change is in the pulse duration, the control action may be to adjust the setting of the pump laser.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. A beam metrology device for determining at least one characteristic of a first radiation and/or at least one characteristic of second radiation, said second radiation being generated via a first nonlinear process upon receiving a first portion of the first radiation; the beam metrology device comprising:
   a metrology device nonlinear medium configured to receive a second portion of the first radiation and thereby to generate third radiation via a second nonlinear process;
   at least one detector configured to measure at least one characteristic of the third radiation; and
   a processing unit operable to determine the at least one characteristic of the first radiation and/or the at least one characteristic of the second radiation based on said at least one characteristic of the third radiation.
2. A beam metrology device as claimed in clause 1, wherein the third radiation has a higher frequency than the first radiation.
3. A beam metrology device as claimed in clause 1 or 2, wherein the second nonlinear process is a second harmonic generation process.
4. A beam metrology device as claimed in clause 1, 2 or 3, wherein the metrology device nonlinear medium is a non-linear crystal.
5. A beam metrology device as claimed in clause 3 or 4, wherein the metrology device nonlinear medium is a BBO crystal or an LBO crystal.
6. A beam metrology device as claimed in preceding clause, wherein the third radiation comprises a central portion and said at least one detector is configured to measure said at least one characteristic of the third radiation from this central portion.
7. A beam metrology device as claimed in clause 6, further comprises a third radiation block configured to block a peripheral portion of the third radiation while transmitting said central portion, said peripheral portion surrounding the central portion of the generated third radiation.
8. A beam metrology device as claimed in any preceding clause, wherein the at least one detector comprises at least one position sensitive detector for determining at least a first position of the third radiation.
9. A beam metrology device as claimed in clause 8, wherein the at least one detector comprises a first position sensitive detector and a second position sensitive detector, the first position sensitive detector and the second position sensitive detector being separated by a distance and configured to measure respectively the first position of the third radiation and a second position of the third radiation.
10. A beam metrology device as claimed in any preceding clause, wherein the at least one detector comprises a wavefront detector configured to measure a wavefront of the third radiation.
11. A beam metrology device as claimed in any preceding clause, wherein the first nonlinear process is a high harmonic generation process.
12. A beam metrology device as claimed in any preceding clause, wherein the first portion of first radiation and the second portion of first radiation each comprises a substantially annular beam.
13. A beam metrology device as claimed in any preceding clause, wherein the processing unit is further operable to determine a control action of at least one characteristic of said first radiation in generating said second radiation based on said at least one characteristic of the third radiation.
14. A beam metrology device as claimed in clause 13 wherein said control action relates to a position and/or direction of the first radiation with respect to a source nonlinear medium for generating the second radiation.
15. A beam metrology device as claimed in clause 13 or 14, wherein said control action relates to a wavefront of the first radiation.
16. A radiation source, comprising:
   a beam metrology device as claimed in clause 13, 14 or 15;
   a source nonlinear medium configured to generate the second radiation via the first nonlinear process upon receiving the first portion of first radiation; and
   a radiation configuration arrangement being operable to configure at least one characteristic of the first radiation so as to actuate said control action.
17. A radiation source as claimed in clause 16, wherein said processing unit is operable to determine the control action of the at least one characteristic of said first radiation so as to minimize a change in at least one characteristic of the second radiation.
18. A radiation source as claimed in clause 17, wherein the processing unit is further configured to:
   receive a signal indicating the at least one characteristic of the third radiation measured by the at least one detector;
   determine a change in the at least one characteristic of the third radiation measured by the at least one detector; and
   generate a control signal for controlling the radiation configuration arrangement so as to counteract the determined change in the measured at least one characteristic of the third radiation.
19. A radiation source as claimed in any of clauses 16 to 18, further comprising a first radiation block operable to transmit substantially only said second radiation while not transmitting any of said first radiation.
20. A radiation source as claimed in clause 19, wherein the first radiation block comprises an aperture or pinhole mirror.
21. A radiation source as claimed in clause 19 or 20, wherein said processing unit is operable to determine the control action of the at least one characteristic of said first radiation so as to minimize or reduce the amount of said first radiation transmitted via said first radiation block and/or maximize or increase the amount of said second radiation transmitted via said first radiation block.
22. A radiation source as claimed in any of clauses 16 to 21, wherein the radiation source further comprises a pick off, the pick off being located upstream the source nonlinear medium and configured to direct the second portion of the first radiation towards the metrology device nonlinear medium.
23. A radiation source as claimed in any of clauses 16 to 21, wherein the radiation source further comprises a pick off, the pick off being located downstream the source nonlinear medium and configured to direct the second portion of the first radiation towards the metrology device nonlinear medium.
24. A radiation source as claimed in clause 22 or 23, the second portion of the first radiation accounts for no more than 5% of the total power of the first radiation.
25. A radiation source as claimed in clause 22 to 24, the second portion of the first radiation accounts for no more than 1% of the total power of the first radiation.
26. A radiation source as claimed in any of clauses 16 to 25, wherein the radiation configuration arrangement comprises one or more beam steering components configured to adjust a position and/or direction of the first radiation with respect to the source nonlinear medium.
27. A radiation source as claimed in clause 26, wherein said one or more beam steering components comprises one or more actuatable mirrors.
28. A radiation source as claimed in any of clauses 16 to 27, wherein the radiation configuration arrangement comprises a wavefront configuration device configured to configure a wavefront of the first radiation.
29. A radiation source as claimed in clause 28, wherein the wavefront configuration device comprises a spatial light modulator, digital micromirror device, or a deformable mirror.
30. A radiation source as claimed in any of clauses 16 to 29, wherein the source nonlinear medium is a gas medium.
31. A radiation source as claimed in clause 30, further comprising:
   a gas delivery system configured to provide a flow of the gas medium; and
   a gas cell and/or a hollow-core fiber configured to at least partially enclose the gas medium.
32. A radiation source as claimed in any of clauses 16 to 31, further comprising a profile configuration arrangement being operable to impose a substantially annular profile to said first radiation.
33. A radiation source as claimed in clause 32, wherein said profile configuration arrangement comprises a negative axicon and a positive axicon.
34. A radiation source as claimed in any of clauses 16 to 33, further comprising a focusing arrangement for focusing the first portion of the first radiation onto the source nonlinear medium so as to generate the second radiation via the first nonlinear process.
35. A radiation source as claimed in any of clauses 16 to 34, further comprising a pump radiation source configured to emit the first radiation.
36. A radiation source as claimed in any of clauses 16 to 35, wherein said third radiation has a higher frequency than said first radiation.
37. A metrology device comprising the radiation source as claimed in any of clauses 16 to 36.
38. A metrology device as claimed in clause 37, comprising a scatterometer metrology apparatus, a holographic microscope, a level sensor or an alignment sensor.
39. A method for controlling a radiation source, comprising:
   generating second radiation via a first nonlinear process upon receiving a first portion of a first radiation by a source nonlinear medium;
   generating third radiation via a second nonlinear process upon receiving a second portion of the first radiation by a metrology nonlinear medium;
   measuring at least one characteristic of the third radiation; and
   controlling said at least one characteristic of said first radiation in generating said second radiation based on said at least one characteristic of the third radiation.
40. A method as claimed in clause 39, wherein said measuring step comprises measuring at least a first position and/or direction of the third radiation.
41. A method as claimed in clause 40, wherein said controlling step comprises controlling a position and/or direction of the first radiation with respect to the source nonlinear medium.
42. A method as claimed in any of clauses 39 to 41, wherein said measuring step comprises measuring at least a wavefront of the third radiation.
43. A method as claimed in clause 42, wherein said controlling step comprises controlling a wavefront of the first radiation.
44. A method as claimed in any of clauses 39 to 43, comprising:
   receiving a signal indicating the at least one characteristic of the third radiation measured by the at least one detector;
   determining a change in the at least one characteristic of the third radiation measured by the at least one detector; and
   generating a control signal for controlling the at least one characteristic of the first radiation so as to counteract the determined change in the measured at least one characteristic of the third radiation.
45. A method as claimed in any of clauses 39 to 44, comprising transmitting substantially only said second radiation while not transmitting any of said first radiation subsequent to generation of said second radiation.
46. A method as claimed in clause 45, wherein said controlling said at least one characteristic of said first radiation comprises controlling said at least one characteristic of said first radiation so as to minimize or reduce the amount of said first radiation transmitted and/or maximize or increase the amount of said second radiation transmitted.
47. A method device as claimed in any of clauses 39 to 46, wherein the second radiation and/or the third radiation has a higher frequency than the first radiation.
48. A method device as claimed in any of clauses 39 to 47, wherein the second nonlinear process is a second harmonic generation process.
49. A method device as claimed in any of clauses 39 to 48, wherein the first nonlinear process is a high harmonic generation process.
50. A method device as claimed in any of clauses 39 to 49, wherein the third radiation comprises a central portion and said measuring step comprises measuring said at least one characteristic of the third radiation from this central portion.
51. A method as claimed in clause 50, wherein the third radiation further comprises a peripheral portion surrounding the central portion, and the method further comprises blocking said peripheral portion of the generated third radiation.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays.

While specific embodiments have been described above, it will be appreciated that one or more of the features in one embodiment may also be present in a different embodiment and that features in two or more different embodiments may also be combined.

## Claims

1. A beam metrology device for determining at least one characteristic of a first radiation and/or at least one characteristic of second radiation, said second radiation being generated via a first nonlinear process upon receiving a first portion of the first radiation; the beam metrology device comprising:
a metrology device nonlinear medium configured to receive a second portion of the first radiation and thereby to generate third radiation via a second nonlinear process;
at least one detector configured to measure at least one characteristic of the third radiation; and
a processing unit operable to determine the at least one characteristic of the first radiation and/or the at least one characteristic of the second radiation based on said at least one characteristic of the third radiation.

2. A beam metrology device as claimed in claim 1, wherein the third radiation has a higher frequency than the first radiation.

3. A beam metrology device as claimed in claim 1 or 2, wherein the second nonlinear process is a second harmonic generation process.

4. A beam metrology device as claimed in claim 1, 2 or 3, wherein the metrology device nonlinear medium is a non-linear crystal.

5. A beam metrology device as claimed in preceding claim, wherein the third radiation comprises a central portion and said at least one detector is configured to measure said at least one characteristic of the third radiation from this central portion.

6. A beam metrology device as claimed in any preceding claim, wherein the at least one detector comprises at least one position sensitive detector for determining at least a first position of the third radiation.

7. A beam metrology device as claimed in claim 6, wherein the at least one detector comprises a first position sensitive detector and a second position sensitive detector, the first position sensitive detector and the second position sensitive detector being separated by a distance and configured to measure respectively the first position of the third radiation and a second position of the third radiation.

8. A beam metrology device as claimed in any preceding claim, wherein the at least one detector comprises a wavefront detector configured to measure a wavefront of the third radiation.

9. A beam metrology device as claimed in any preceding claim, wherein the first nonlinear process is a high harmonic generation process.

10. A beam metrology device as claimed in any preceding claim, wherein the first portion of first radiation and the second portion of first radiation each comprises a substantially annular beam.

11. A beam metrology device as claimed in any preceding claim, wherein the processing unit is further operable to determine a control action of at least one characteristic of said first radiation in generating said second radiation based on said at least one characteristic of the third radiation.

12. A beam metrology device as claimed in claim 11 wherein said control action relates to a position and/or direction of the first radiation with respect to a source nonlinear medium for generating the second radiation.

13. A beam metrology device as claimed in claim 11 or 12, wherein said control action relates to a wavefront of the first radiation.

14. A radiation source, comprising:
a beam metrology device as claimed in claim 11, 12 or 13;
a source nonlinear medium configured to generate the second radiation via the first nonlinear process upon receiving the first portion of first radiation; and
a radiation configuration arrangement being operable to configure at least one characteristic of the first radiation so as to actuate said control action.

15. A method for controlling a radiation source, comprising:
generating second radiation via a first nonlinear process upon receiving a first portion of a first radiation by a source nonlinear medium;
generating third radiation via a second nonlinear process upon receiving a second portion of the first radiation by a metrology nonlinear medium;
measuring at least one characteristic of the third radiation; and
controlling said at least one characteristic of said first radiation in generating said second radiation based on said at least one characteristic of the third radiation.
